# FASCICULE DE BREVET EUROPEEN

(11) **EP 2 392 062 B1**
(45) Date de publication et mention de la délivrance du brevet: **26.11.2014**
(21) Numéro de dépôt: 10707598.8
(22) Date de dépôt: 27.01.2010
(51) Int. Cl.: H02H 3/02, G05F 1/571

(54) **DISPOSITIF DE SURVEILLANCE ET DE PROTECTION DE L'ALIMENTATION D'UN APPAREIL ÉLECTRIQUE ET PROCÉDÉ DE MISE EN OEUVRE DE CE DISPOSITIF**
EINRICHTUNG ZUM ÜBERWACHEN UND SCHÜTZEN DER STROMVERSORGUNG EINES ELEKTRISCHEN GERÄTS UND VERFAHREN ZUM IMPLEMENTIEREN DER EINRICHTUNG
DEVICE FOR MONITORING AND PROTECTING THE POWER SUPPLY OF AN ELECTRIC APPLIANCE, AND METHOD FOR IMPLEMENTING SAID DEVICE

(30) Priorité: 28.01.2009 FR 0900366
(43) Date de publication de la demande: 07.12.2011
(73) Titulaire: Gascuel, Jacques, 31350 Peguilhan (FR)
(72) Inventeur: Gascuel, Jacques, 31350 Peguilhan (FR)
(74) Mandataire: Cabinet BARRE LAFORGUE & associés
(86) Numéro de dépôt international: PCT/FR2010/050125
(87) Numéro de publication internationale: WO 2010/086552

(56) Documents cités:
- FR-A- 2 666 901
- US-A- 3 359 434
- US-A- 4 566 052
- US-A- 5 959 816

## Description

L'invention concerne un dispositif de surveillance et de protection de l'alimentation en énergie électrique d'un appareil électrique permettant d'identifier et d'enregistrer des anomalies survenant sur l'alimentation afin d'en définir les causes et le cas échéant, les responsables. L'invention concerne également un procédé de mise en oeuvre d'un tel dispositif.

Les systèmes électriques et électroniques actuels, comme les ordinateurs par exemple, sont formés de plusieurs appareils interconnectés et alimentés à partir du secteur par l'intermédiaire d'une alimentation stabilisée qui fournit à chaque appareil (carte-mère, processeur, disques, etc.) une source d'énergie adaptée à ses caractéristiques en termes de tension, courant, etc.

Une défaillance ou une anomalie de cette alimentation peut entrainer des conséquences catastrophiques pour les appareils qui y sont reliés. Si dans la plupart des cas, la conséquence est la destruction de l'appareil entrainant son remplacement et un coût afférent limité au coût du matériel, il existe cependant des cas dans lesquels le coût du matériel ne représente qu'une très faible part des coûts encourus. Par exemple, la défaillance d'un disque dur ou d'une banque de mémoires peut entrainer une perte de données ayant des conséquences opérationnelles et financières importantes. Même s'il existe des possibilités (limitées) de récupérer certaines informations, leur mise en oeuvre est extrêmement coûteuse elle aussi. La défaillance d'autres appareils peut également entrainer des pertes d'exploitation avec des conséquences tout aussi importantes.

On connaît de nombreux dispositifs de protection d'appareils électriques, susceptible de protéger également la source d'énergie qui les alimente, comme par exemple du document FR 2 830 379, qui décrit un dispositif de protection d'une charge et de sa source d'énergie électrique, comportant un circuit de limitation de tension et un circuit de limitation de courant pouvant fonctionner également en limitation de puissance consommée. Un autre exemple de ces dispositifs est divulgué par le document US 3 359 434. Néanmoins, d'autres anomalies de l'alimentation de la charge peuvent survenir pour lesquelles ce dispositif n'est pas prévu, comme par exemple une surtension qui dépasserait la valeur maximale de tension que pourrait bloquer le commutateur de ce dispositif. En outre, malgré l'efficacité des dispositifs de protection, il est toujours possible qu'une défaillance de l'appareil protégé se produise.

Les victimes de sinistres de ce type sont donc enclines à se tourner vers des assurances pour couvrir ce risque ou à rechercher d'éventuels responsables pour être indemnisées. Cependant, dans l'état actuel de la technique, il est très difficile de déterminer a posteriori la cause d'un tel sinistre et d'en rechercher les responsables, la défaillance d'un appareil pouvant être due à l'appareil lui-même ou bien être causée par des éléments externes comme une anomalie de l'alimentation en énergie électrique de l'appareil ou des conditions d'environnement anormales.

Il y a donc un besoin pour un dispositif qui permette d'une part, d'améliorer l'étendue de la protection d'un appareil et d'autre part, en cas d'anomalie ou de défaillance, d'en enregistrer précisément les circonstances.

L'invention vise donc un dispositif de surveillance et de protection d'un appareil électrique qui permette de protéger cet appareil contre une large gamme d'anomalies d'alimentation.

L'invention vise également un tel dispositif qui soit susceptible de protéger également la source d'énergie contre une anomalie induite par une défaillance de l'appareil protégé.

L'invention vise encore un dispositif capable de surveiller et d'enregistrer et de sauvegarder de manière fiable et pérenne, certains paramètres représentatifs de l'alimentation et de l'environnement de l'appareil protégé lorsqu'une anomalie survient.

L'invention vise encore un dispositif susceptible d'être associé de manière fiable et pérenne avec l'appareil qu'il est destiné à surveiller et à protéger de manière à ce qu'on ne puisse pas contester l'authenticité des événements survenus à cet appareil, déterminés en fonction des paramètres enregistrés dans le dispositif.

L'invention vise encore un dispositif de surveillance et de protection d'un appareil électrique qui permette de signaler localement et le cas échéant à distance, les anomalies détectées.

L'invention vise encore un dispositif qui puisse servir de support et d'élément de preuve dans un nouveau service d'assurance plus efficace et performant pour des sinistres susceptibles d'affecter l'appareil protégé.

Pour ce faire, l'invention concerne un dispositif de surveillance et de protection d'un appareil électrique, placé sur une ligne d'alimentation en série entre une source d'énergie électrique et ledit appareil, comportant :
- au moins un régulateur de tension adapté pour réguler une tension d'alimentation de l'appareil lorsqu'une tension d'entrée délivrée par la source d'énergie est comprise entre une valeur inférieure de fonctionnement et une valeur supérieure de fonctionnement, et pour couper cette tension d'alimentation lorsque la tension d'entrée est en dehors desdites valeurs de fonctionnement,
- au moins un limiteur de courant, couplé au régulateur de tension, adapté pour réduire la tension d'alimentation de l'appareil si un courant d'alimentation absorbé par l'appareil excède une valeur supérieure de fonctionnement,
- au moins un court-circuit pilotable, adapté pour être déclenché lorsque la tension d'entrée excède une valeur limite de sécurité, supérieure à la valeur supérieure de fonctionnement et entrainer la coupure d'un fusible placé en série entre la source d'énergie et l'appareil, et
- des moyens de calcul et de mémorisation adaptés pour générer une horloge et enregistrer une date d'occurrence d'une anomalie et des paramètres de fonctionnement de l'alimentation de l'appareil dans une mémoire non volatile.

Même si la source d'énergie électrique est un bloc d'alimentation dite stabilisée, des moyens de protection supplémentaires, couplés ensemble, permettent de pallier d'éventuelles défaillances du bloc d'alimentation ou des conséquences de problèmes électriques pouvant survenir sur des appareils alimentés en parallèle. Ainsi, le régulateur de tension n'alimente l'appareil protégé que si la tension d'entrée est comprise dans des limites de fonctionnement normal, le limiteur de courant coopère avec le régulateur de tension pour limiter la tension d'alimentation de l'appareil si celui-ci venait à absorber un excès de courant révélateur d'une panne interne telle qu'un court-circuit et, dans le cas où une surtension d'un niveau susceptible d'endommager l'appareil et/ou le régulateur de tension se présenterait sur la ligne d'alimentation, le coupe circuit constitué par le fusible et le court-circuit pilotable isolerait l'ensemble du dispositif et de l'appareil en interrompant la ligne d'alimentation entre la source d'énergie et le dispositif. Dans le cas d'appareils comportant plusieurs lignes d'alimentation (par exemple pour plusieurs tensions d'alimentation), chaque ligne comporte un jeu de moyens de protection (régulateur de tension, limiteur de courant, court-circuit pilotable) reliés à des moyens de calcul et de mémorisation communs. Outre la protection renforcée apportée par le dispositif de l'invention, celui-ci comporte des moyens permettant de dater et d'enregistrer la date de survenance d'une anomalie ainsi que d'enregistrer des mesures des paramètres de fonctionnement tels que la tension d'entrée, la tension d'alimentation de l'appareil et le courant consommé par celui-ci, permettant ainsi de déterminer la nature de l'anomalie. Les données recueillies sont avantageusement enregistrées dans une mémoire non volatile, et de préférence non modifiable de manière à pouvoir être relues même en cas de destruction partielle du dispositif et de l'appareil qu'il protège et être utilisées en vue de déterminer les éventuelles responsabilités dans la survenance de l'anomalie.

Avantageusement, dans un premier mode de réalisation de l'invention, le régulateur de tension, le limiteur de courant et le court-circuit pilotable sont adaptés pour fonctionner de manière autonome et indépendante des moyens de calcul et de mémorisation et les moyens de calcul et de mémorisation sont adaptés pour enregistrer dans ladite mémoire non volatile la date et les paramètres de fonctionnement de l'alimentation de l'appareil sur une durée prédéterminée. Dans cette version du dispositif de protection, les moyens de protection fonctionnent de manière autonome et parallèlement à la partie enregistrement des défaillances. Les paramètres de fonctionnement sont enregistrés de manière glissante sur une durée ou un nombre d'enregistrements prédéterminé.

Dans une variante de ce premier mode de réalisation de l'invention, le régulateur de tension, le limiteur de courant et le court-circuit pilotable sont adaptés pour générer un signal d'interruption à destination des moyens de calcul et de mémorisation lorsqu'ils sont activés, ledit signal déclenchant l'enregistrement de la date et des paramètres de fonctionnement de l'alimentation de l'appareil dans ladite mémoire non volatile. Dans cette variante, le dispositif enregistre une « photographie » de l'état du dispositif lorsqu'au moins un des moyens de protection se déclenche, c'est-à-dire au moment où survient une anomalie.

Dans un second mode de réalisation du dispositif selon l'invention, le régulateur de tension, le limiteur de courant et le court-circuit pilotable sont adaptés pour être commandés par les moyens de calcul et de mémorisation en fonction des paramètres de fonctionnement de l'alimentation de l'appareil et de leur comparaison avec des valeurs prédéterminées, l'enregistrement de la date et des paramètres de fonctionnement de l'alimentation de l'appareil dans ladite mémoire non volatile étant géré par les moyens de calcul et de mémorisation. Dans ce mode de réalisation, le dispositif présente l'avantage d'être entièrement programmable, tant pour les limites de fonctionnement que pour la fréquence et la quantité des enregistrements conservés.

Avantageusement et selon l'invention, les moyens de calcul et de mémorisation comportent en outre une mémoire non modifiable adaptée pour enregistrer de manière permanente une information d'identification de l'appareil protégé. De cette manière, il est possible d'associer de manière infalsifiable le dispositif de surveillance et de protection selon l'invention avec l'appareil qu'il protège.

Avantageusement et selon l'invention, le régulateur de tension comporte une entrée de commande et les moyens de calcul et de mémorisation sont adaptés pour commander une mise sous tension ou hors tension de l'appareil en fonction de la survenance d'événements prédéterminés. Cette caractéristique, conjuguée avec la présence d'une horloge dans les moyens de calcul et de mémorisation, permet de réaliser sans coût supplémentaire une programmation de plages horaires de fonctionnement ou d'arrêt de l'appareil protégé.

Avantageusement et selon l'invention, le dispositif de surveillance et de protection comporte au moins un capteur adapté pour mesurer un paramètre d'environnement de l'appareil et/ou du dispositif. Par exemple, le capteur est pris parmi l'ensemble des capteurs de température, d'hygrométrie et d'accélération.

Avantageusement et selon l'invention, les moyens de calcul et de mémorisation sont adaptés pour comparer la valeur dudit paramètre avec des limites prédéterminées et commander une mise sous tension ou hors tension de l'appareil en cas de franchissement desdites limites par ledit paramètre. Il est ainsi possible de mettre hors tension un appareil lorsque la température ambiante, l'humidité ou l'accélération (en cas de chute par exemple) franchissent un seuil prédéterminé et de remettre l'appareil sous tension lorsque les conditions d'environnement redeviennent acceptables.

Avantageusement et selon l'invention, les moyens de calcul et de mémorisation sont en outre adaptés pour enregistrer l'instant d'occurrence et la nature d'une anomalie de l'environnement de l'appareil. De cette manière, on pourra savoir si une défaillance a été entraînée par une exposition de l'appareil à des conditions d'environnement allant au-delà de ses spécifications.

Avantageusement et selon l'invention, le dispositif de surveillance et de protection comporte des moyens de communication adaptés pour établir une liaison d'échange d'informations avec un système externe. Ces moyens de communication, par exemple sous la forme d'une liaison filaire série, USB ou encore sans fil (WIFI, GSM...) permettent la programmation du dispositif ainsi que le recueil des données enregistrées dans sa mémoire. Ces moyens de communication peuvent également être reliés par l'intermédiaire d'un ordinateur externe et/ou d'un réseau (LAN, WAN) à des systèmes distants de télésurveillance ou autre.

Avantageusement et selon l'invention, le dispositif de surveillance et de protection comporte en outre des moyens de signalisation adaptés pour signaler l'instant d'occurrence et la nature d'une anomalie de l'alimentation et/ou de l'environnement de l'appareil. En fonction de la nature et du coût de l'appareil protégé, la signalisation d'une anomalie peut aller d'un simple signal sonore (bip) ou de voyants lumineux jusqu'à une signalisation à distance faisant usage des moyens de communication précités.

Avantageusement et selon l'invention, le dispositif de surveillance et de protection comporte une source d'énergie autonome indépendante de la source d'énergie à laquelle il est relié. De cette manière, même en cas de coupure de la ligne d'alimentation, par exemple par rupture du fusible entrainée par le court circuit pilotable, les moyens de calcul et d'enregistrement restent fonctionnels pendant une durée suffisante pour sauvegarder les données acquises lors de l'anomalie.

Avantageusement et selon l'invention, le dispositif de surveillance et de protection est miniaturisé et intégré dans un boitier d'un connecteur d'alimentation de l'appareil à protéger.

L'invention s'étend également à un procédé de mise en oeuvre d'un dispositif de surveillance et de protection d'un appareil électrique tel que décrit ci-dessus, caractérisé en ce qu'il comporte :
- une étape d'initialisation du dispositif au cours de laquelle un programme et des valeurs limites de fonctionnement sont enregistrés dans une mémoire non volatile,
- une étape d'identification de l'appareil protégé par le dispositif au cours de laquelle une information d'identification dudit appareil est enregistrée dans une mémoire non volatile et non modifiable,
- une étape de surveillance et protection au cours de laquelle des paramètres d'alimentation et d'environnement du dispositif protégé sont collectés et comparés aux valeurs limites de fonctionnement enregistrées à l'étape d'initialisation,
- une étape d'enregistrement d'anomalie et d'alerte déclenchée par l'occurrence d'une anomalie d'un paramètre d'alimentation et/ou d'environnement excédant les valeurs limites de fonctionnement enregistrées,
- une étape de restitution et d'analyse d'anomalie au cours de laquelle une cause initiale de l'anomalie est déterminée à partir des paramètres enregistrés lors de l'occurrence de l'anomalie.

L'invention concerne également un dispositif et un procédé de surveillance et de protection d'un appareil électrique caractérisé en combinaison par tout ou partie des caractéristiques mentionnées ci-dessus ou ci-après.

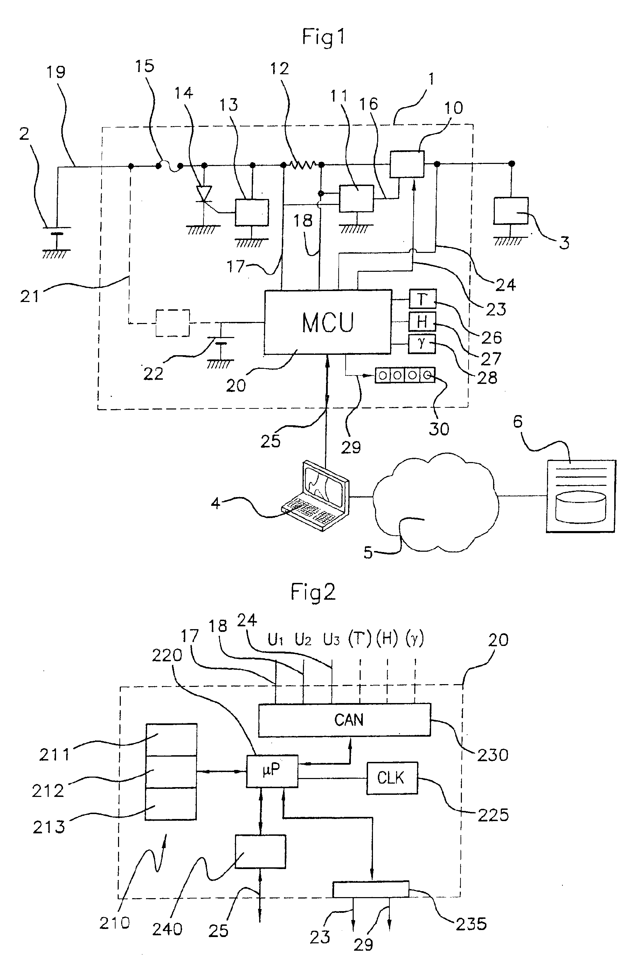

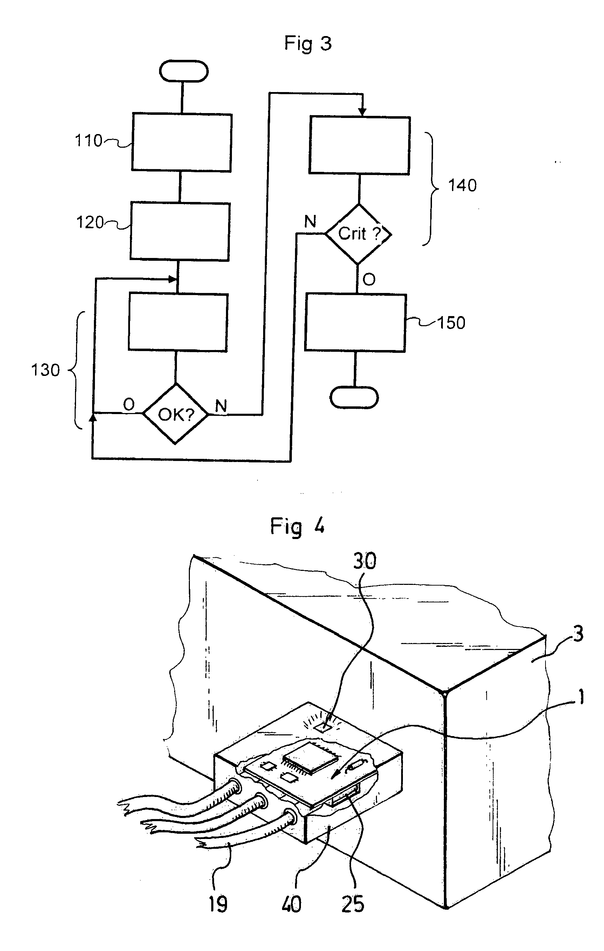

D'autres buts, caractéristiques et avantages de l'invention apparaîtront au vu de la description qui va suivre et des dessins annexés dans lesquels :
■ la figure 1 est un schéma fonctionnel d'un dispositif selon l'invention,
■ la figure 2 est un schéma fonctionnel des moyens de calcul et de mémorisation du dispositif selon l'invention,
■ la figure 3 est un logigramme du procédé de mise en oeuvre du dispositif selon l'invention,
■ la figure 4 est une vue partielle d'un appareil protégé par un dispositif selon l'invention intégré dans un connecteur d'alimentation.

La figure 1 représente schématiquement un dispositif 1 de surveillance et de protection d'un appareil 3 électrique selon un premier mode de réalisation. Le dispositif 1 est placé en série sur une ligne d'alimentation 19 entre une source d'énergie 2, qui est par exemple une alimentation stabilisée fournissant une alimentation électrique à différents appareils constituant un ordinateur, tels que carte mère, processeur, disque dur, disque optique, etc. et un appareil 3 qui, dans l'exemple décrit est un disque dur d'ordinateur.

En partant de la connexion à l'appareil 3, le dispositif 1 comporte en série sur la ligne d'alimentation 19 un régulateur de tension 10, la résistance de mesure 12 d'un limiteur de courant 11 et un fusible 15. Le fusible 15 est relié d'une part à la source d'énergie 2 et d'autre part à l'anode d'un thyristor 14 dont la cathode est reliée à la masse. Le thyristor 14 fonctionne en court-circuit pilotable par un détecteur de surtension 13. Le détecteur de surtension 13 est branché entre la ligne d'alimentation 19 et la masse et comporte une borne de commande reliée à la gâchette du thyristor 14.

Le limiteur de courant 11 mesure le courant d'alimentation circulant dans la ligne d'alimentation 19 par l'intermédiaire de la chute de tension aux bornes de la résistance de mesure 12. D'autres moyens bien connus de mesure du courant peuvent être employés par l'homme du métier, comme par exemple un miroir de courant. Le limiteur de courant 11 est adapté pour coopérer avec le régulateur de tension 10 par l'intermédiaire d'une ligne de couplage 16 permettant de modifier la tension de sortie du régulateur de tension 10 si le courant d'alimentation excède une valeur limite prédéterminée.

Le régulateur de tension 10 reçoit en entrée une tension d'entrée délivrée par la source d'énergie 2 et fournit en sortie une tension d'alimentation régulée à l'appareil 3. Le régulateur comporte de façon connue en elle-même un transistor (ou équivalent) en série entre l'entrée et la sortie du régulateur, ce transistor étant adapté pour fonctionner en commutation ou en mode linéaire en fonction de la tension d'entrée.

Le dispositif de surveillance et de protection de la figure 1 comporte également des moyens de calcul et de mémorisation sous la forme d'un microcontrôleur 20 dont la structure et le fonctionnement seront détaillés en relation avec la figure 2. Le microcontrôleur 20 est alimenté par une source d'énergie autonome 22, par exemple une pile ou un accumulateur au lithium, indépendante de la source d'énergie 2. De cette manière, même en cas de coupure de la ligne d'alimentation 19, le microcontrôleur continue d'être alimenté et peut accomplir des opérations postérieurement à la survenance d'une anomalie. La source d'énergie autonome 22 peut également être utilisée pour alimenter des éléments (signalisation, communication, etc.) du dispositif 1 qui doivent rester fonctionnels après une anomalie.

Le microcontrôleur 20 comprend essentiellement un bloc mémoire 210, un processeur 220, une horloge 225, un convertisseur analogique-numérique 230 comportant de multiples entrées, une interface de commande 235 et une interface de communication 240.

Le bloc mémoire 210 comporte plusieurs zones de mémoire, présentant des caractéristiques distinctes. Par exemple, une première zone mémoire, dite mémoire non modifiable 211, est réalisée par des circuits de mémoire de type PROM, inscriptibles une seule fois et non effaçables, adaptée pour contenir des données d'identification du dispositif 1 de surveillance et de protection, telles que son numéro de série, et des données d'identification de l'appareil qu'il protège (fabricant, modèle, numéro de série, etc.)

Le bloc mémoire 210 comprend encore une deuxième zone de mémoire dite mémoire programme 212, de type EEPROM ou mémoire flash, non volatile, adaptée pour contenir le programme de fonctionnement du microcontrôleur ainsi que des données pérennes telles que les valeurs limites de fonctionnement du dispositif 1 (valeurs supérieure et inférieure de fonctionnement en tension, valeur supérieure de fonctionnement en courant, valeur limite de sécurité, etc.) Ces données et le programme de fonctionnement sont en général inscrits dans la mémoire en usine, lors de la fabrication du dispositif 1. Ils peuvent néanmoins être mis à jour au cours de l'utilisation du dispositif, mais l'accès à cette zone de mémoire est susceptible d'être soumis à un processus d'identification / autorisation afin d'en contrôler les conditions de modification.

Une troisième zone de mémoire, dite mémoire de travail 213, non volatile, par exemple de même type que la mémoire programme 212, est adaptée pour recevoir des valeurs numériques représentant des mesures des paramètres de fonctionnement du dispositif 1 et de l'appareil 3 ainsi que des informations de date associées à ces mesures.

L'horloge 225 du microcontrôleur est adaptée pour fournir des informations d'horodatage comprenant par exemple année, mois, jour, heure, minute et seconde permettant de dater aussi précisément que possible un instant d'occurrence d'un événement tel que l'instant auquel une mesure est effectuée, par exemple.

Le convertisseur analogique-numérique 230 est adapté pour recevoir en entrée et mesurer des paramètres de fonctionnement du dispositif 1 et de l'appareil 3. Il reçoit la tension d'entrée du dispositif par une ligne de mesure 17 connectée à la borne commune de la source d'énergie 2 et de la résistance 12, la tension à l'autre borne de la résistance 12 par une ligne de mesure 18, permettant de calculer le courant circulant dans la ligne d'alimentation 19, et la tension d'alimentation de l'appareil 3 par une ligne de mesure 24 connectée à la borne commune du régulateur de tension 10 et de l'appareil 3.

Le convertisseur analogique-numérique 230 est également adapté pour recevoir et mesurer des valeurs représentatives de paramètres d'environnement du dispositif 1 délivrés par des capteurs inclus dans le dispositif, tels qu'un capteur de température 26, d'hygrométrie 27 ou d'accélération 28, ou encore de tout autre capteur apte à mesurer un paramètre physique susceptible de présenter un intérêt dans l'environnement d'exploitation de l'appareil 3.

Le microcontrôleur 20 comporte également une interface de commande 235 adaptée pour fournir des signaux de commande à certains éléments du dispositif 1, et en particulier, par l'intermédiaire de la ligne de commande 23, un signal de commande du régulateur de tension 10 permettant la mise sous tension ou hors tension de l'appareil 3. L'interface de commande est également adaptée pour commander par une ligne de commande 29 un bloc de signalisation 30, comprenant une ou plusieurs diodes électroluminescentes ou un vibreur sonore.

Le microcontrôleur 20 comporte en outre une interface de communication 240 permettant de connecter, par une ligne de communication 25 physique ou virtuelle, le dispositif 1 à un système externe tel qu'un ordinateur 4, lui-même connecté par exemple à un serveur 6 via un réseau 5 (internet ou réseau privé). Cette interface de communication peut être de type filaire, selon des normes connues (USB, RS232 ou autres) ou le cas échéant, sans fil de type WIFI, GSM, Bluetooth, ZigBee, etc.

Dans un premier mode de réalisation du dispositif de l'invention, les moyens de protection formés par le régulateur de tension 10, le limiteur de courant 11 et le coupe circuit constitué par le fusible 15, le thyristor 14 et le détecteur de surtension 13 sont adaptés pour fonctionner de manière autonome et indépendante du microcontrôleur 20. Dans ce cas, les composants formant les moyens de protection sont choisis ou ajustés pour délimiter des valeurs de fonctionnement du dispositif correspondant à l'appareil à protéger.

Le régulateur de tension 10 est par exemple adapté pour fournir une tension d'alimentation de l'appareil 3 correspondant aux spécifications de celui-ci, par exemple de 5 ± 0,5 volts pour un disque dur. Le régulateur est adapté pour fonctionner avec une tension d'entrée, fournie par la source d'énergie 2, comprise entre une valeur inférieure de fonctionnement (par exemple 4,5V) et une valeur supérieure de fonctionnement (par exemple 7,5V). Pour une tension d'entrée inférieure à la valeur inférieure de fonctionnement, le régulateur est adapté pour couper l'alimentation de l'appareil. Pour une valeur de tension d'entrée excédant la valeur supérieure de fonctionnement, le régulateur est de même adapté pour couper l'alimentation de l'appareil. Pour une tension d'entrée comprise par exemple entre 5,5V et la valeur supérieure de fonctionnement, le régulateur fonctionne en mode linéaire dans la limite de la puissance qu'il peut dissiper. Si cette puissance est dépassée, le régulateur coupe également l'alimentation de l'appareil.

Le régulateur de tension 10 est cependant limité quant à la tension d'entrée maximale qu'il peut supporter, même lorsque l'alimentation de l'appareil 3 est coupée. Par exemple, une défaillance de la source d'énergie qui conduirait à la présence d'une tension secteur de 220V sur la ligne d'alimentation 19 entrainerait la destruction du régulateur et de l'appareil qui lui est relié. Afin de parer à cette éventualité, le détecteur de surtension 13 est adapté pour commander la gâchette du thyristor 14 lorsque la tension d'entrée dépasse une valeur limite de sécurité, supérieure à la valeur supérieure de fonctionnement du régulateur mais inférieure à la tension maximale supportable par le régulateur à l'état bloqué. Ainsi, dès que cette valeur limite de sécurité est dépassée, le thyristor 14 est commandé en court-circuit, entrainant un courant de court-circuit dans le fusible 15 qui fond et isole de la source d'énergie les circuits en aval, c'est-à-dire l'essentiel du dispositif 1 et l'appareil 3.

Dans le cas où, par exemple à cause d'une défaillance interne de l'appareil 3, celui-ci se met en court-circuit (même partiellement), le courant d'alimentation absorbé par l'appareil peut croitre et excéder une valeur supérieure de fonctionnement. Afin de protéger d'une part la source d'énergie 2 mais aussi les parties de l'appareil 3 qui pourraient souffrir d'une surchauffe liée à ce court-circuit, le limiteur de courant 11 impose, par l'intermédiaire de la ligne de couplage 16, une chute de tension aux bornes du régulateur de tension en vue de réduire la tension d'alimentation de l'appareil 3 et de réduire concomitamment le courant qui le traverse. Si le court-circuit disparaît, le courant absorbé par l'appareil 3 diminue et l'ensemble revient à la normale. Si le courant continue à augmenter, les limites supérieures en tension et/ou en puissance du régulateur de tension 10 sont dépassées et le régulateur interrompt l'alimentation de l'appareil.

Dans ce premier mode de réalisation, les moyens de protection du dispositif 1 fonctionnent de manière autonome, selon des valeurs limites fixées à la fabrication du dispositif. Le microcontrôleur 20 reçoit lors de cette fabrication un programme de fonctionnement et des données représentatives de ces valeurs limites, qui sont mémorisées dans la zone mémoire 212.

Au cours du fonctionnement du dispositif 1 de surveillance et de protection, le microcontrôleur 20 mesure périodiquement les différents paramètres de fonctionnement (tension d'entrée, courant consommé, tension d'alimentation de l'appareil, le cas échéant, température, humidité, accélération...) et enregistre la valeur et la date de la mesure dans la mémoire de travail 213. Ces enregistrements s'effectuent de manière glissante, c'est-à-dire que lorsque la mémoire de travail est pleine, chaque nouvel enregistrement vient remplacer le plus ancien enregistrement précédemment enregistré.

Pour chaque mesure effectuée, le microcontrôleur 20 compare la valeur de la mesure aux valeurs limites enregistrées dans sa mémoire programme. En cas de dépassement de l'une au moins des limites, une anomalie est constatée. En fonction du programme du microcontrôleur, plusieurs types de traitement peuvent être envisagés : l'enregistrement correspondant peut être marqué non effaçable et conservé à fins d'exploitation ultérieure, ou bien, par exemple si l'anomalie est identifiée comme critique, tous les enregistrements précédents sont sauvegardés, etc. Par exemple, une mesure de la tension d'entrée présentant un pic positif suivi d'une ou plusieurs mesures de valeur sensiblement nulle est révélatrice du déclenchement du coupe-circuit pilotable et de la rupture du fusible 15. Ou encore une chute brutale du courant consommé accompagnée d'un pic de la tension d'alimentation de l'appareil 3 peut être considérée comme révélatrice d'une anomalie (circuit ouvert) de l'entrée d'alimentation de l'appareil 3.

On constate qu'ainsi il est possible, en analysant les enregistrements effectués par le microcontrôleur 20, de déterminer le type d'anomalie survenue et son origine éventuelle (coté source d'énergie 2 ou appareil 3). De même, l'enregistrement concomitant des valeurs des paramètres d'environnement (température, hygrométrie, accélération...) est susceptible de fournir des renseignements quant aux possibles causes externes de l'anomalie.

Le dispositif 1 de surveillance et de protection peut être également programmé pour qu'un franchissement d'une valeur limite par l'un des paramètres d'environnement mesurés par le microcontrôleur 20 entraine une mise en sécurité de l'appareil protégé. A cet effet, le régulateur de tension 10 comporte une entrée de commande reliée par la ligne de commande 23 à l'interface de commande 235 du microcontrôleur. Cette commande permet de forcer le régulateur de tension 10 à interrompre l'alimentation de l'appareil 3. Le microcontrôleur 20 est ainsi adapté pour effectuer une mise hors tension de l'appareil 3 lorsque l'un des paramètres d'environnement surveillés franchit une valeur limite programmée dans la mémoire programme 212 et le remettre sous tension lorsque la valeur du paramètre revient à la normale. Bien entendu, chaque commande fait l'objet d'un enregistrement dans la mémoire de travail, comportant au moins la date et la nature de l'anomalie d'environnement constatée, ainsi que les valeurs des paramètres mesurés à l'instant d'occurrence de l'anomalie.

En outre, le microcontrôleur 20 comportant une horloge capable de délivrer un signal horaire, il est possible sans ajout matériel supplémentaire de réaliser une fonction de mise sous tension (respectivement hors tension) à des instants prédéterminés, par exemple en programmant des valeurs de date dans la mémoire programme 212 et en effectuant une comparaison de la date courante avec ces valeurs. La programmation de ces valeurs de date peut être avantageusement réalisée au travers de l'interface de communication 240 du microcontrôleur par exemple au moyen du système externe 4 ou d'un appareil dédié. Bien entendu, des événements autres que des dates ou des franchissements de limites peuvent être programmés dans le microcontrôleur 20, à la survenance desquels le microcontrôleur est adapté pour commander une mise sous tension ou hors tension de l'appareil 3.

Dans une variante de ce premier mode de réalisation du dispositif de surveillance et de protection selon l'invention, les moyens de protection formés par le régulateur de tension 10, le limiteur de courant 11 et le coupe circuit constitué par le fusible 15, le thyristor 14 et le détecteur de surtension 13 sont reliés en parallèle par une ligne d'interruption (non représentée) connectée au microcontrôleur 20 et adaptée pour déclencher une interruption du processeur 220 et commander l'exécution d'une routine prédéterminée lorsque l'un au moins des moyens de protection est activé. Par exemple, lorsque le régulateur de tension 10 coupe l'alimentation de l'appareil 3 du fait d'une tension d'entrée en dehors des limites fixées, ou lorsque le limiteur de courant 11 commande au régulateur l'abaissement de la tension d'alimentation de l'appareil 3, ou encore lorsque le détecteur de surtension 13 commande la gâchette du thyristor 14, l'état de la ligne d'interruption change et force le microcontrôleur 20 à exécuter une routine de traitement d'anomalie dans laquelle les valeurs des paramètres d'alimentation et d'environnement du dispositif sont mesurées par le convertisseur analogique-numérique 230 et enregistrées dans la mémoire de travail 213 en même temps que la date courante fournie par l'horloge 225. Dans cette variante, à l'inverse du mode de réalisation principal où l'enregistrement des données s'effectue en permanence, l'enregistrement est déclenché par la survenance d'une anomalie. Le dispositif peut être programmé pour mémoriser un ou plusieurs enregistrements consécutifs. De cette manière la mémoire de travail n'est pas sollicitée en continu, mais seules les mesures postérieures à la survenance de l'anomalie sont enregistrées.

Dans un second mode de réalisation de l'invention, les moyens de protection du dispositif sont contrôlés par le microcontrôleur 20. Dans ce mode de réalisation, comme dans le précédent, le microcontrôleur 20 effectue des mesures périodiques des différents paramètres de fonctionnement (tension d'entrée, courant consommé, tension d'alimentation de l'appareil, le cas échéant, température, humidité, accélération...) et compare la valeur de la mesure aux valeurs limites enregistrées dans sa mémoire programme. Cependant, les moyens de protection sont adaptés pour être commandés par des sorties du bloc de commande 235 du microcontrôleur. Par exemple, la gâchette du thyristor 14 est directement commandée par le microcontrôleur, lorsque la tension mesurée sur la ligne de mesure 17 excède un seuil prédéterminé. Le détecteur de surtension 13 n'est alors plus nécessaire. De même, la commande du régulateur de tension 10 peut être adaptée pour commander celui-ci de manière linéaire et non plus en tout ou rien. De cette façon, le microcontrôleur 20 peut piloter la tension de sortie du régulateur et donc la tension d'alimentation de l'appareil 3 en fonction de la différence de tension aux bornes de la résistance de mesure 12 (représentative du courant d'alimentation) et de la valeur absolue de ces tensions. De la même manière, le microcontrôleur 20 commande la mise hors tension ou sous tension de l'appareil 3 en fonction des mesures des paramètres d'environnement (température, hygrométrie, accélération...) et de leur comparaison aux valeurs limites enregistrées dans sa mémoire programme.

En cas de dépassement de l'une au moins des limites, une anomalie est constatée et le microcontrôleur commande l'enregistrement des différents paramètres mesurés ainsi que de la date d'occurrence de l'anomalie.

L'avantage de ce second mode de réalisation du dispositif de surveillance et de protection selon l'invention réside dans son aptitude à être programmé avec des limites adaptées à une pluralité d'appareils 3 dans une certaine gamme de tensions et de courants. De cette manière, la fabrication du dispositif peut être standardisée et son adaptation au dispositif à protéger peut être réalisée au moment de l'association avec celui-ci.

Quel que soit le mode de réalisation envisagé pour le dispositif, celui-ci est prévu pour être miniaturisé et intégré, comme montré à la figure 4, dans un connecteur 40 d'alimentation de l'appareil 3. Le connecteur 40 reçoit au moins la ligne d'alimentation 19 en provenance de la source d'énergie. Cette ligne d'alimentation est connectée à une plaquette support, par exemple un circuit imprimé ou hybride, formant le dispositif 1 de surveillance et de protection. Le dispositif 1 peut être avantageusement surmoulé à l'intérieur du connecteur 40. La sortie du dispositif 1 est directement reliée aux broches de connexion (non visibles sur la figure) du connecteur 40 à l'appareil 3. Avantageusement, le bloc de signalisation 30 consiste en une diode électroluminescente visible au travers du surmoulage. Une ligne de communication 25, représentée sous la forme d'un connecteur pour une liaison filaire, est accessible sur le coté du connecteur 40. Bien entendu, la ligne de communication pourrait également être réalisée par un câble parallèle à la ligne d'alimentation 19 ou, comme vu précédemment, par tout autre moyen de communication sans fil.

On va maintenant décrire, en relation avec la figure 3, un procédé de mise en oeuvre du dispositif de surveillance et de protection selon l'invention, particulièrement adapté au support de la mise en oeuvre d'un service d'assurance de l'appareil protégé.

Le procédé de mise en oeuvre du dispositif selon l'invention comporte une première étape 110 d'initialisation du dispositif, au cours ou en fin de fabrication de celui-ci. Lors de cette initialisation, chaque dispositif 1 reçoit un numéro de série qui est enregistré dans sa mémoire non modifiable 211 de manière à être identifié de manière unique. Le dispositif reçoit également au moins une partie de son programme de fonctionnement. Cette partie consiste en un programme de fonctionnement minimal comportant au moins toutes les instructions permettant au microcontrôleur 20 de gérer son interface de communication afin par exemple de pouvoir ultérieurement télécharger d'autres parties complémentaires de programme ou des mises à jour, etc. Dans le cas d'un dispositif 1 réalisé selon le premier mode de réalisation de l'invention, les valeurs limites de fonctionnement qui correspondent aux ajustements réalisés en fabrication sur les moyens de protection sont également enregistrées dans la mémoire programme 212. En outre, dès lors que la source d'énergie autonome du dispositif a été mise en place, l'horloge 225 est mise en route et sa mise à l'heure est effectuée.

On note qu'au terme de cette étape d'initialisation, le dispositif 1 est en fonctionnement (au moins selon un programme minimal) et capable d'enregistrer des mesures relatives à son environnement s'il est équipé des capteurs appropriés. Ceci permet de s'assurer que le dispositif 1 n'a pas été soumis avant sa mise en service chez le client à des conditions susceptibles de l'avoir endommagé.

Le procédé de mise en oeuvre du dispositif 1 comprend ensuite une étape d'identification 120 de l'appareil 3 à protéger lors de sa mise en service chez le client. Lors de cette étape, le dispositif 1 est branché en série entre la source d'énergie 2 et l'appareil 3. Sa ligne de communication 25 est connectée au système externe 4. Dans un cas particulier, le système externe 4 peut être l'ordinateur auquel l'appareil 3 est raccordé.

Au cours de cette étape 120, différentes opérations sont exécutées. A titre d'exemple non limitatif, le programme de fonctionnement minimal peut prévoir de manière autonome ou sous le contrôle d'un programme particulier prévu dans le système externe 4, de procéder à l'identification du type d'appareil auquel il est connecté, par exemple en lisant les données d'identification mémorisées dans la mémoire de l'appareil (fabricant, modèle, type, numéro de série, version, etc.). A partir de ces informations, le dispositif 1 est susceptible de télécharger, via sa connexion au système externe 4 et au-delà, par le réseau internet 5, à un serveur 6, un éventuel complément de programme adapté à l'appareil 3 ainsi que (par exemple pour un dispositif selon le second mode de réalisation) des valeurs limites de fonctionnement propres à cet appareil.

Le dispositif 1, plus particulièrement le microcontrôleur 20, est adapté pour enregistrer les données d'identification de l'appareil 3 auquel il est apparié dans sa mémoire non effaçable de manière à réaliser un appairage définitif et à garantir l'absence de substitution d'appareil en cas d'anomalie. Il peut être en outre prévu, au cours de cette étape d'identification, de procéder à l'inscription du couple dispositif / appareil sur un site distant, par exemple le site internet d'un assureur, en association avec des données relatives au client, pour une éventuelle mise en oeuvre ultérieure d'une garantie souscrite auprès de cet assureur.

A l'issue de ces opérations, le procédé de mise en oeuvre du dispositif passe à une étape de surveillance et de protection 130. Dans cette étape, le dispositif 1 exécute les opérations de mesure des paramètres de fonctionnement et d'environnement, les compare aux valeurs limites contenues dans sa mémoire programme et enregistre ces valeurs de mesure et la date courante dans sa mémoire de travail 213. Cette étape est répétée tant qu'aucune anomalie n'est détectée.

Lorsqu'une anomalie est détectée, soit par la mise en action d'un des moyens de protection du dispositif 1, soit par une mesure d'un paramètre d'alimentation et/ou d'environnement franchissant l'une des valeurs limites enregistrées dans la mémoire programme, le procédé de mise en oeuvre du dispositif passe à une étape 140 de traitement d'anomalie dans laquelle l'une au moins des opérations de traitement d'anomalie suivantes est exécutée : l'enregistrement courant des valeurs de mesure et de la date est noté comme anomalie et par exemple marqué comme non effaçable ; une anomalie est signalée par le bloc de signalisation 30 ; le cas échéant, une alarme est transmise vers un site distant par l'interface de communication 240 et la ligne de communication 25 ; l'exécution d'un sous-programme d'évaluation de la criticité de l'anomalie ; etc.

Dans le cas où le programme de fonctionnement du dispositif 1 prévoit une telle évaluation de criticité, en fonction de celle-ci le procédé peut revenir à l'étape de surveillance et de protection ou bien mettre le dispositif et l'appareil protégé hors tension et passer à l'étape suivante. S'il n'est pas prévu d'évaluation de la criticité de l'anomalie permettant de continuer les opérations de surveillance et de protection, le procédé passe à l'étape 150 de restitution et d'analyse dans laquelle un opérateur ou un système expert intervient pour extraire de la mémoire de travail les différentes informations enregistrées avant et pendant l'anomalie et en faire une interprétation avancée, permettant le cas échéant de déterminer les causes et les responsabilités associées.

Bien entendu, cette description est donnée à titre d'exemple illustratif uniquement et l'homme du métier pourra y apporter de nombreuses modifications sans sortir de la portée de l'invention, comme par exemple intégrer aux capteurs d'environnement des valeurs limites pré-ajustées et adapter ces capteurs à commander directement le régulateur de tension 10 en parallèle sur la ligne de commande 23, ou encore adapter le programme de fonctionnement des moyens de calcul et de mémorisation afin de prévoir plusieurs niveaux de sécurité et/ou de confidentialité afin que la lecture ou la modification des données enregistrées ne puisse être réalisée que par des personnes dûment autorisées.

## Revendications

1. Dispositif (1) de surveillance et de protection d'un appareil (3) électrique, placé sur une ligne d'alimentation (19) en série entre une source d'énergie électrique (2) et ledit appareil, comportant :
- au moins un régulateur de tension (10) adapté pour réguler une tension d'alimentation de l'appareil (3) lorsque qu'une tension d'entrée délivrée par la source d'énergie (2) est comprise entre une valeur inférieure de fonctionnement et une valeur supérieure de fonctionnement, et pour couper cette tension d'alimentation lorsque la tension d'entrée est en dehors desdites valeurs de fonctionnement,
- au moins un limiteur de courant (11), couplé au régulateur de tension (10), adapté pour réduire la tension d'alimentation de l'appareil (3) si un courant d'alimentation absorbé par l'appareil excède une valeur supérieure de fonctionnement,
- au moins un court-circuit (13, 14) pilotable, adapté pour être déclenché lorsque la tension d'entrée excède une valeur limite de sécurité, supérieure à la valeur supérieure de fonctionnement et entrainer la coupure d'un fusible (15) placé en série entre la source d'énergie (2) et l'appareil (3), et
- des moyens (20) de calcul et de mémorisation adaptés pour générer une horloge (225) et enregistrer une date d'occurrence d'une anomalie et des paramètres de fonctionnement de l'alimentation de l'appareil dans une mémoire (213) non volatile,
**caractérisé en ce que** le régulateur de tension (10), le limiteur de courant (11) et le court-circuit (13, 14) pilotable sont adaptés pour être commandés par les moyens (20) de calcul et de mémorisation en fonction des paramètres de fonctionnement de l'alimentation de l'appareil (3) et de leur comparaison avec des valeurs prédéterminées, l'enregistrement de la date et des paramètres de fonctionnement de l'alimentation de l'appareil dans ladite mémoire (213) non volatile étant déclenché par les moyens (20) de calcul et de mémorisation.

2. Dispositif selon la revendication 1, **caractérisé en ce que** le régulateur de tension (10), le limiteur de courant (11) et le court-circuit (13, 14) pilotable sont adaptés pour générer un signal d'interruption à destination des moyens (20) de calcul et de mémorisation lorsqu'ils sont activés, ledit signal déclenchant l'enregistrement de la date et des paramètres de fonctionnement de l'alimentation de l'appareil dans ladite mémoire (213) non volatile.

3. Dispositif selon l'une des revendications 1 ou 2, **caractérisé en ce que** les moyens (20) de calcul et de mémorisation comportent en outre une mémoire (211) non modifiable adaptée pour enregistrer de manière permanente une information d'identification de l'appareil (3) protégé.

4. Dispositif selon l'une des revendications 1 à 3, **caractérisé en ce que** le régulateur de tension (10) comporte une entrée de commande (23) et **en ce que** les moyens (20) de calcul et de mémorisation sont adaptés pour commander une mise sous tension ou hors tension de l'appareil (3) en fonction de la survenance d'événements prédéterminés.

5. Dispositif selon l'une des revendications 1 à 4, **caractérisé en ce qu'**il comporte au moins un capteur (26, 27, 28) adapté pour mesurer un paramètre d'environnement de l'appareil (3) et/ou du dispositif (1).

6. Dispositif selon la revendication 5, **caractérisé en ce que** le capteur est pris parmi l'ensemble des capteurs de température, d'hygrométrie et d'accélération.

7. Dispositif selon l'une des revendications 5 ou 6, **caractérisé en ce que** les moyens (20) de calcul et de mémorisation sont adaptés pour comparer la valeur dudit paramètre avec des limites prédéterminées et commander une mise sous tension ou hors tension de l'appareil (3) en cas de franchissement desdites limites par ledit paramètre.

8. Dispositif selon l'une des revendications 5 à 7, **caractérisé en ce que** les moyens (20) de calcul et de mémorisation sont en outre adaptés pour enregistrer l'instant d'occurrence et la nature d'une anomalie de l'environnement de l'appareil.

9. Dispositif selon l'une des revendications 1 à 8, **caractérisé en ce qu'**il comporte en outre des moyens de communication (240, 25) adaptés pour établir une liaison d'échange d'informations avec un système (4) externe.

10. Dispositif selon l'une des revendications 1 à 9, **caractérisé en ce qu'**il comporte en outre des moyens de signalisation (30) adaptés pour signaler l'instant d'occurrence et la nature d'une anomalie de l'alimentation et/ou de l'environnement de l'appareil (3).

11. Dispositif selon l'une des revendications 1 à 10, **caractérisé en ce qu'**il comporte une source d'énergie autonome (22) indépendante de la source d'énergie (2) à laquelle il est relié.

12. Dispositif selon l'une des revendications 1 à 11, **caractérisé en ce qu'**il est miniaturisé et intégré dans un boitier d'un connecteur (40) d'alimentation de l'appareil (3) à protéger.

13. Procédé de mise en oeuvre d'un dispositif (1) de surveillance et de protection d'un appareil (3) selon l'une quelconque des revendications précédentes, **caractérisé en ce qu'**il comporte :
- une étape (110) d'initialisation du dispositif au cours de laquelle un programme et des valeurs limites de fonctionnement sont enregistrés dans une mémoire (212) non volatile,
- une étape (120) d'identification de l'appareil protégé par le dispositif au cours de laquelle une information d'identification dudit appareil est enregistrée dans une mémoire (211) non volatile et non effaçable,
- une étape (130) de surveillance et protection au cours de laquelle des paramètres d'alimentation et d'environnement de l'appareil (3) protégé sont collectés et comparés aux valeurs limites de fonctionnement enregistrées à l'étape d'initialisation,
- une étape d'enregistrement d'anomalie et d'alerte déclenchée par l'occurrence d'une anomalie d'un paramètre d'alimentation et/ou d'environnement excédant les valeurs limites de fonctionnement enregistrées,
- une étape de restitution et d'analyse d'anomalie au cours de laquelle une cause initiale de l'anomalie est déterminée à partir des paramètres enregistrés lors de l'occurrence de l'anomalie.

## Patentansprüche

1. Vorrichtung (1) zum Überwachen und zum Schutz eines elektrischen Geräts (3), die auf einer Versorgungsleitung (19) in Reihe zwischen einer elektrischen Energiequelle (2) und dem Gerät angeordnet ist, umfassend:
- mindestens einen Spannungsregler (10), der ausgelegt ist, um eine Versorgungsspannung des Geräts (3) zu regeln, wenn eine Eingangsspannung, die von der Energiequelle (2) geliefert wird, zwischen einem unteren Betriebswert und einem oberen Betriebswert liegt, und um diese Versorgungsspannung zu unterbrechen, wenn die Eingangsspannung außerhalb der Betriebswerte liegt,
- mindestens einen Strombegrenzer (11), der mit dem Spannungsregler (10) gekoppelt ist, der ausgelegt ist, um die Versorgungsspannung des Geräts (3) zu reduzieren, wenn ein Versorgungsstrom, der vom Gerät aufgenommen wird, einen oberen Betriebswert übersteigt,
- mindestens einen steuerbaren Kurzschluss (13, 14), der ausgelegt ist, um ausgelöst zu werden, wenn die Eingangsspannung einen Sicherheits-Grenzwert übersteigt, der größer als der obere Betriebswert ist, und zur Unterbrechung einer Sicherung (15) zu führen, die in Reihe zwischen der Energiequelle (2) und dem Gerät (3) angeordnet ist, und
- Mittel (20) zur Berechnung und zur Speicherung, die ausgelegt sind, um eine Uhr (225) zu erzeugen und ein Datum des Auftretens eines Defekts und Betriebsparameter der Versorgung des Geräts in einem nicht flüchtigen Speicher (213) aufzuzeichnen,
**dadurch gekennzeichnet, dass** der Spannungsregler (10), der Strombegrenzer (11) und der steuerbare Kurzschluss (13, 14) ausgelegt sind, um von den Mitteln (20) zur Berechnung und zur Speicherung je nach Funktionsparametern der Versorgung des Geräts (3) und ihrem Vergleich mit vorbestimmten Werten gesteuert zu werden, wobei die Aufzeichnung des Datums und der Betriebsparameter der Versorgung des Geräts in dem nicht flüchtigen Speicher (213) durch die Mittel (20) zur Berechnung und zur Speicherung ausgelöst wird.

2. Vorrichtung nach Anspruch 1, **dadurch gekennzeichnet, dass** der Spannungsregler (10), der Strombegrenzer (11) und der steuerbare Kurzschluss (13, 14) ausgelegt sind, um ein Unterbrechungssignal an die Mittel (20) zur Berechnung und zur Speicherung zu erzeugen, wenn sie aktiviert sind, wobei das Signal die Aufzeichnung des Datums und der Betriebsparameter der Versorgung des Geräts in dem nicht flüchtigen Speicher (213) auslöst.

3. Vorrichtung nach einem der Ansprüche 1 oder 2, **dadurch gekennzeichnet, dass** die Mittel (20) zur Berechnung und zur Speicherung außerdem einen nicht modifizierbaren Speicher (211) umfassen, der ausgelegt ist, um auf permanente Weise eine Information zur Identifizierung des geschützten Geräts (3) aufzuzeichnen.

4. Vorrichtung nach einem der Ansprüche 1 bis 3, **dadurch gekennzeichnet, dass** der Spannungsregler (10) einen Steuereingang (23) umfasst, und dadurch, dass die Mittel (20) zur Berechnung und zur Speicherung ausgelegt sind, um ein Einschalten oder Ausschalten des Geräts (3) je nach dem Auftreten von vorbestimmten Ereignissen zu steuern.

5. Vorrichtung nach einem der Ansprüche 1 bis 4, **dadurch gekennzeichnet, dass** sie mindestens einen Sensor (26, 27, 28) umfasst, der ausgelegt ist, um einen Parameter der Umgebung des Geräts (3) und/oder der Vorrichtung (5) zu messen.

6. Vorrichtung nach Anspruch 5, **dadurch gekennzeichnet, dass** der Sensor ausgewählt ist aus der Gruppe der Temperatur-, Hygrometrie- und Beschleunigungssensoren.

7. Vorrichtung nach einem der Ansprüche 5 oder 6, **dadurch gekennzeichnet, dass** die Mittel (20) zur Berechnung und zur Speicherung ausgelegt sind, um den Wert des Parameters mit vorbestimmten Grenzen zu vergleichen und eine Einschalten oder Ausschalten des Geräts (3) für den Fall des Überschreitens der Grenzen durch den Parameter zu steuern.

8. Vorrichtung nach einem der Ansprüche 5 bis 7, **dadurch gekennzeichnet, dass** die Mittel (20) zur Berechnung und zur Speicherung außerdem ausgelegt sind, um den Zeitpunkt des Auftretens und die Art eines Defekts der Umgebung des Geräts aufzuzeichnen.

9. Vorrichtung nach einem der Ansprüche 1 bis 8, **dadurch gekennzeichnet, dass** sie außerdem Mittel zur Kommunikation (240, 25) umfasst, die ausgelegt sind, um eine Verbindung zum Austausch von Informationen mit einem externen System (4) aufzubauen.

10. Vorrichtung nach einem der Ansprüche 1 bis 9, **dadurch gekennzeichnet, dass** sie außerdem Mittel zur Signalisierung (30) umfasst, die ausgelegt sind, um den Zeitpunkt des Auftretens und die Art eines Defekts der Versorgung und/oder der Umgebung des Geräts (3) zu signalisieren.

11. Vorrichtung nach einem der Ansprüche 1 bis 10, **dadurch gekennzeichnet, dass** sie eine autonome Energiequelle (22) umfasst, die unabhängig von der Energiequelle (2) ist, mit der sie verbunden ist.

12. Vorrichtung nach einem der Ansprüche 1 bis 11, **dadurch gekennzeichnet, dass** sie miniaturisiert und in ein Gehäuse eines Versorgungssteckers (40) des Geräts (3), das geschützt werden soll, integriert ist.

13. Verfahrung zur Durchführung einer Vorrichtung (1) zur Überwachung und zum Schutz eines Geräts (3) nach einem der vorhergehenden Ansprüche, **dadurch gekennzeichnet, dass** es Folgendes umfasst:
- einen Schritt (110) des Initialisierens der Vorrichtung, in dessen Verlauf ein Programm und Betriebs-Grenzwerte in einem nicht flüchtigen Speicher (212) aufgezeichnet werden,
- einen Schritt (120) des Identifizierens des Geräts, das durch die Vorrichtung geschützt wird, in dessen Verlauf eine Information zur Identifizierung des Geräts in einem nicht flüchtigen und nicht löschbaren Speicher (211) aufgezeichnet wird,
- einen Schritt (130) des Überwachens und des Schützens, in dessen Verlauf Parameter der Versorgung und der Umgebung des geschützten Geräts (3) gesammelt und mit den Grenz-Betriebswerten verglichen werden, die beim Schritt des Initialisierens aufgezeichnet wurden,
- einen Schritt des Aufzeichnens des Defekts und des Alarms, ausgelöst durch das Auftreten eines Defekts eines Parameters der Versorgung- und/oder der Umgebung, der die aufgezeichneten Betriebs-Grenzwerte übersteigt,
- einen Schritt des Wiederherstellens und des Analysierens des Defekts, in dessen Verlauf eine anfängliche Ursache des Defekts auf der Grundlage der Parameter bestimmt wird, die beim Auftreten des Defekts ausgezeichnet wurden.

## Claims

1. Device (1) for monitoring and protecting electrical equipment (3), placed in series on a power supply line (19) between an electrical power source (2) and said equipment, comprising:
- at least one voltage regulator (10) adapted to regulate a power supply voltage of the equipment (3) when an input voltage delivered by the power source (2) is between a lower operating value and an upper operating value, and to cut off said power supply voltage when the input voltage is outside said operating values,
- at least one current limiter (11), coupled to the voltage regulator (10), and adapted to reduce the power supply voltage of the equipment (3) if a power supply current absorbed by the equipment exceeds an upper operating value,
- at least one crowbar short-circuit device (13, 14), adapted to be activated when the input voltage exceeds a safety limit value that is higher than the upper operating value and to cause a fuse (15) placed in series between the power source (2) and the equipment (3), to blow, and
- means (20) of calculation and storage, adapted for generating a clock (225) and logging a date of occurrence of a fault and the operating parameters of the power supply for the equipment in a non-volatile memory (213),
wherein the voltage regulator (10), the current limiter (11) and the crowbar short-circuit device (13, 14) are adapted to be controlled by the means (20) of calculation and storage according to the operating parameters of the power supply for the equipment (3) and their comparison with the predetermined values, the logging of the date and operating parameters of the power supply for the equipment in said volatile memory (213) being triggered by the means (20) of calculation and storage.

2. Device as claimed in Claim 1, wherein the voltage regulator (10), the current limiter (11) and the crowbar short-circuit device (13, 14) are adapted to generate an interrupt signal towards the means (20) of calculation and storage when they are activated, said signal triggering the logging of the date and operating parameters of the power supply for the equipment in said non-volatile memory (213).

3. Device as claimed in one of claims 1 or 2, wherein the means (20) of calculation and storage additionally comprise a non-modifiable memory (211) adapted for permanently logging information for identifying the protected equipment (3).

4. Device as claimed in one of claims 1 to 3, wherein the voltage regulator (10) comprises a control input (23) and wherein the means (20) of calculation and storage are adapted to control a connection to or disconnection from the power supply of the equipment (3) according to the occurrence of predetermined events.

5. Device as claimed in one of claims 1 to 4, wherein it comprises at least one sensor (26, 27, 28) adapted for measuring an environmental parameter of the equipment (3) and/or of the device (1).

6. Device as claimed in Claim 5, wherein the sensor is one of a set of sensors for temperature, hygrometry and acceleration.

7. Device as claimed in one of claims 5 or 6, wherein the means (20) of calculation and storage are adapted to compare the value of said parameter with the predetermined limits, and to control a connection to or disconnection from the power supply of the equipment (3) if said limits are exceeded by said parameter.

8. Device as claimed in one of claims 5 to 7, wherein the means (20) of calculation and storage are additionally adapted to log the instant of occurrence and the nature of a fault in the environment of the equipment.

9. Device as claimed in one of claims 1 to 8, wherein it additionally comprises means of communication (240, 25) adapted for establishing a connection for exchanging information with an external system (4).

10. Device as claimed in one of claims 1 to 9, wherein it additionally comprises means of signalisation (30) adapted to signal the instant of occurrence and the nature of a fault in the power supply and/or in the environment of the equipment (3).

11. Device as claimed in one of claims 1 to 10, wherein it comprises an autonomous power source (22) that is independent of the power source (2) to which it is connected.

12. Device as claimed in one of claims 1 to 11, wherein it is miniaturized and integrated into a housing of a power connector (40) of the equipment (3) to be protected.

13. Method for implementing a device (1) for monitoring and protecting equipment (3) as claimed in any one of the above claims, wherein it comprises:
- a step (110) for initialization of the device during which a programme and operating limit values are recorded in a non-volatile memory (212),
- a step (120) for identification of the protected equipment by the device during which information for identifying said equipment is recorded in a non-volatile and non-erasable memory (211),
- a step (130) for monitoring and protection during which the power supply and environmental parameters of the protected equipment (3) are gathered and compared to the operating limit values recorded at the initialization step,
- a step for the logging and signalling of a fault, initiated by the occurrence of a fault caused by a power supply and/or environmental parameter exceeding the registered operating limit values,
- a step for restitution and analysis of the fault during which an initial cause for the fault is determined on the basis of the parameters logged at the time the fault occurred.
